# EUROPEAN PATENT APPLICATION

(11) **EP 4 822 588 A1**
(43) Date of publication of application: **14.10.2026**
(21) Application number: 24900221.3
(22) Date of filing: 15.08.2024
(51) Int. Cl.: G06K 7/10, H05K 9/00

(54) **MOUNTING ARTICLE AND READING SYSTEM**

(30) Priority: 04.12.2023 JP 2023204892
(71) Applicant: TEIJIN FRONTIER CO., LTD., Osaka-shi, Osaka 530-0005 (JP)
(72) Inventor: YAMADA, Yasuhiro, Osaka-shi, Osaka 530-0005 (JP); KUWABARA, Yuki, Osaka-shi, Osaka 530-0005 (JP); NEGISHI, Tsuyoto, Osaka-shi, Osaka 530-0005 (JP); KUBOTA, Kou, Osaka-shi, Osaka 530-0005 (JP); ASAMURA, Naoya, Tokyo 112-0012 (JP)
(74) Representative: Carpmaels & Ransford LLP
(86) International application number: PCT/JP2024/029111
(87) International publication number: WO 2025/120924

(57) **Abstract**

A mounter (110) is mounted on a body part of a user. A storage (150) is fixed to the mounter (110) and stores a reading device to read tag information of a wireless tag. A cover (160) covers the storage (150). The mounter (110) includes a propagator including a reader brought close to the wireless tag and an arranger in which the reading device is arranged, the propagator propagating radio waves used for reading the tag information. The cover (160) includes a first shielding body having a sheet shape and covering at least one full periphery of the storage (150).

## Description

### Technical Field

The present disclosure relates to a mounting article and a reading system.

### Background Art

A technique for managing articles by using a reading device to read tag information from a wireless tag attached to an article is known. Currently, various kinds of techniques for reducing labor required for reading tag information are known.

For example, Patent Literature 1 describes a reader-equipped working supply that is a working supply worn by a worker and equipped with a reading device. The reader-equipped working supply automatically reads tag information from a wireless tag of an article upon approach of the reading device to the wireless tag when the worker handles the article.

### Citation List

### Patent Literature

Patent Literature 1: Unexamined Japanese Patent Application Publication No. 2013-130991

### Summary of Invention

### Technical Problem

However, in the reader-equipped working supply described in Patent Literature 1, radio waves used for reading tag information are inadequately controlled, and tag information may be read from an unintended wireless tag. That is, in the reader-equipped working supply described in Patent Literature 1, accuracy in reading tag information is considered low. Thus, improving accuracy in reading tag information is desired.

The present disclosure has been made in view of the above problem, and an objective of the present disclosure is to provide a mounting article and the like having high accuracy in reading tag information.

### Solution to Problem

To achieve the aforementioned objective, a mounting article according to a first aspect of the present disclosure includes:
a mounter to be mounted on a body part of a user;
a storage fixed to the mounter and configured to store a reading device to read tag information of a wireless tag; and
a cover to cover the storage, in which
the mounter includes a propagator including a reader brought close to the wireless tag and an arranger in which the reading device is arranged, the propagator being configured to propagate radio waves used for reading the tag information, and
the cover includes a first shielding body having a sheet shape and configured to cover at least one full periphery of the storage.

The first shielding body may be arranged in two layers on an opposite side from the body part of the user as seen from the reading device.

The cover may be arranged in such a way that the first shielding body covers the storage and the arranger of the propagator together.

The mounter may include a second shielding body having a sheet shape and arranged in such a way as to sandwich the arranger of the propagator between the second shielding body and the reading device.

The cover may be arranged in such a way that the first shielding body covers the storage, the arranger of the propagator, and the second shielding body together.

The storage may be arranged on a wrist of the user when the mounting article is mounted, and the mounter may include a strip-shaped member having a strip shape and including the propagator.

The strip-shaped member may be hooked between fingers of the user when the mounting article is mounted.

The strip-shaped member may include a stretch member having stretchability.

To achieve the aforementioned objective, a reading system according to a second aspect of the present disclosure is a reading system including a mounting article to be mounted on a user and a reading device to read tag information of a wireless tag, in which
the mounting article includes
   a mounter to be mounted on a body part of the user,
   a storage fixed to the mounter and configured to store the reading device, and
   a cover to cover the storage,
the mounter includes a propagator including a reader brought close to the wireless tag and an arranger in which the reading device is arranged, the propagator being configured to propagate radio waves used for reading the tag information, and
the cover includes a first shielding body having a sheet shape and configured to cover at least one full periphery of the storage.

### Advantageous Effects of Invention

The present disclosure can provide a mounting article and the like having high accuracy in reading tag information.

### Brief Description of Drawings

FIG. 1 is a configuration diagram of a reading system according to Embodiment 1;
FIG. 2 is an external view of a mounting article according to Embodiment 1;
FIG. 3 is an external view of the mounting article according to Embodiment 1 when mounted;
FIGS. 4A and 4B are each a view illustrating a mounter of the mounting article according to Embodiment 1, FIG. 4A being a view illustrating how a front side of the mounter looks, FIG. 4B being a view illustrating how a back side of the mounter looks;
FIGS. 5A and 5B are each a view illustrating a ribbon support of the mounter of the mounting article according to Embodiment 1, FIG. 5A is a view illustrating how a front side of the ribbon support looks, and FIG. 5B is a view illustrating how a back side of the ribbon support looks;
FIGS. 6A and 6B are each a view illustrating a storage of the mounting article according to Embodiment 1, FIG. 6A is a view illustrating the storage before sewing, and FIG. 6B is a view illustrating the storage after sewing;
FIGS. 7A and 7B are each a view illustrating a cover of the mounting article according to Embodiment 1, FIG. 7A is a view illustrating how a front side of the cover looks, and FIG. 7B is a view illustrating how a back side of the cover looks;
FIG. 8 is an exploded perspective view of the cover of the mounting article according to Embodiment 1;
FIG. 9 is a plan view of the mounting article according to Embodiment 1 when mounted;
FIG. 10 is a sectional view along a line A-A in FIG. 9;
FIG. 11 is a diagram illustrating materials of each layer in the sectional view in FIG. 10;
FIG. 12 is a sectional view along a line B-B in FIG. 9;
FIG. 13 is a diagram illustrating materials of each layer in the sectional view in FIG. 12;
FIG. 14 is a side view of a mounting article according to Embodiment 2;
FIG. 15 is a top view of the mounting article according to Embodiment 2;
FIG. 16 is a first external view of the mounting article according to Embodiment 2 when mounted; and
FIG. 17 is a second external view of the mounting article according to Embodiment 2 when mounted.

### Description of Embodiments

Hereinafter, embodiments of the present disclosure are described with reference to drawings. Note that, in the drawings, the same or equivalent parts are denoted by the same reference signs.

### Embodiment 1

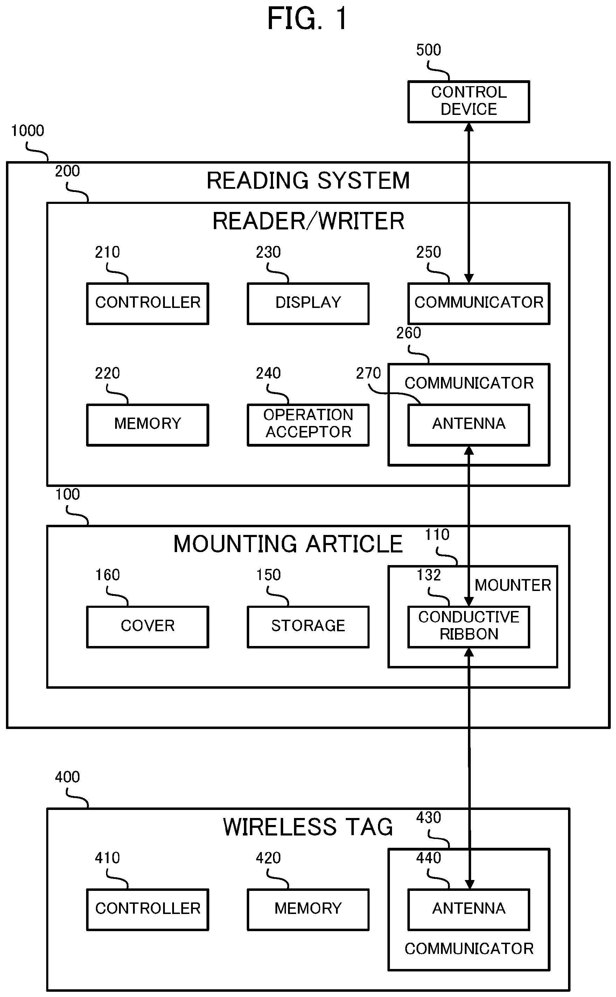

First, a configuration of a reading system 1000 according to Embodiment 1 is described with reference to FIG. 1. The reading system 1000 is a system that reads tag information from a wireless tag 400 attached to an article to be managed. The tag information is information for identifying the wireless tag 400 or an article to which the wireless tag 400 is attached, and is, for example, information indicating a character string including numerical values or alphabets. The article to be managed may be an article managed in a warehouse, a factory, a hospital, or the like, or may be an article in transit in logistics. The reading system 1000 is used by being mounted on a body part of a user. The reading system 1000 automatically reads tag information from the wireless tag 400 in close proximity to a part of the reading system 1000.

As illustrated in FIG. 1, the reading system 1000 includes a mounting article 100 and a reader/writer 200. The mounting article 100 is an article to be mounted on a body part of a user and for fixing the reader/writer 200 to a body part of a user. The mounting article 100 has a function of storing the reader/writer 200 and a function of propagating radio waves used by the reader/writer 200. The mounting article 100 includes a mounter 110, a storage 150, and a cover 160.

The mounter 110 is a member to be mounted on a body part of a user. In the present embodiment, the mounter 110 is mounted on a non-dominant hand of a user. For example, the mounter 110 is mounted on the left hand of a right-handed user. The mounter 110 includes a conductive ribbon 132 functioning as a propagator that propagates radio waves used for reading tag information. As described later, the conductive ribbon 132 includes a reader brought close to the wireless tag 400 and an arranger in which the reader/writer 200 is arranged.

The storage 150 is a member fixed to the mounter 110 and configured to store the reader/writer 200 to read tag information of the wireless tag 400. The cover 160 is a member to cover the storage 150. As described later, the cover 160 includes a first shielding body having a sheet shape and configured to cover at least around the storage 150. The cover 160 is arranged in such a way that the first shielding body covers the storage 150 and the arranger of the propagator together.

Further, as described later, the mounter 110 includes a second shielding body. The second shielding body has a sheet shape and is arranged in such a way as to sandwich the arranger of the propagator between the second shielding body and the reader/writer 200. The cover 160 is arranged in such a way that the first shielding body covers the storage 150, the arranger of the propagator, and the second shielding body together. The mounter 110 is one example of the mounter. The conductive ribbon 132 is one example of the propagator. The storage 150 is one example of the storage. The cover 160 is one example of the cover.

The reader/writer 200 reads tag information from the wireless tag 400 and writes tag information to the wireless tag 400 according to control by a control device 500. Note that, in the present embodiment, reading of tag information is described, and description about writing of tag information is omitted. The reader/writer 200 is a device that is operated by a rechargeable battery and does not require power supply from an external power source.

When reading tag information, the reader/writer 200 emits radio waves for power supply from an antenna 270. The radio waves for power supply are radio waves for supplying power to the passive wireless tag 400 and including a command for the wireless tag 400. The command is, for example, a command requesting for transmission of tag information. In the present embodiment, the reader/writer 200 reads tag information at predetermined cycles according to control by the control device 500. The cycle is, for example, one second.

Further, when the antenna 270 receives tag information-containing radio waves, the reader/writer 200 transmits tag information indicated by the tag information-containing radio waves to the control device 500. The tag information-containing radio waves are radio waves including tag information, and the wireless tag 400 having received radio waves for power supply emits the tag information-containing radio waves with the radio waves for power supply as an operating power source. In the present embodiment, the reader/writer 200 reads tag information from the wireless tag 400 by a radio transmission scheme using radio waves of ultra-high frequency (UHF) band frequencies, that is, frequencies between 300 MHz and 3 GHz (for example, 920 MHz). The reader/writer 200 is one example of the reading device.

The reader/writer 200 includes a controller 210, a memory 220, a display 230, an operation acceptor 240, a communicator 250, and a communicator 260. The controller 210 controls an overall operation of the reader/writer 200. The controller 210 includes, for example, a processor operating according to an operating program stored in the memory 220. The memory 220 stores various kinds of information. The memory 220 stores, for example, the above-described operating program.

The display 230 displays various kinds of information according to control by the controller 210. The display 230 includes a light emitting diode (LED), a liquid crystal display, and the like. The operation acceptor 240 accepts various kinds of information from a user. The operation acceptor 240 supplies the accepted information to the controller 210. The operation acceptor 240 may include a switch for operating a power source of the reader/writer 200. The operation acceptor 240 includes a switch, a lever, a button, and the like.

The communicator 250 communicates with the control device 500 according to control by the controller 210. The communicator 250 includes a communication interface compliant with well-known wireless communication standards such as, for example, Bluetooth (registered trademark), Wi-Fi (registered trademark), Long Term Evolution (LTE, registered trademark), 4th Generation (4G), and 5th Generation (5G).

The communicator 260 communicates with the wireless tag 400 according to control by the controller 210. The communicator 260 communicates with the wireless tag 400 via the conductive ribbon 132 included in the mounter 110. The communicator 260 includes the antenna 270. The antenna 270 emits radio waves for power supply. Further, the antenna 270 captures tag information-containing radio waves emitted from the wireless tag 400. The antenna 270 is, for example, a dipole antenna.

The wireless tag 400 stores tag information for identifying an article to be managed, and is attached to the article to be managed. In the present embodiment, the wireless tag 400 is a passive tag that is a tag having no on-board battery among wireless integrated circuit (IC) tags in a radio frequency identification (RFID) system. That is, the wireless tag 400 emits tag information-containing radio waves in response to receiving radio waves for power supply, with the radio waves for power supply as an operating power source.

The wireless tag 400 includes a controller 410, a memory 420, and a communicator 430. The controller 410 controls an overall operation of the wireless tag 400. The controller 410 includes, for example, a processor operating according to an operating program stored in the memory 420. When an antenna 440 captures radio waves for power supply, the controller 410 emits tag information-containing radio waves from the antenna 440. The memory 420 stores various kinds of information. The memory 420 stores, for example, the above-described operating program and tag information.

The communicator 430 communicates with the reader/writer 200 according to control by the controller 410. The communicator 430 communicates with the reader/writer 200 via the propagator included in the mounter 110. The communicator 430 includes the antenna 440. The antenna 440 captures radio waves for power supply emitted by the reader/writer 200. Further, the antenna 440 emits tag information-containing radio waves including tag information.

The control device 500 is a device that controls the reader/writer 200. For example, the control device 500 instructs the reader/writer 200 to read tag information. Further, the control device 500 receives tag information from the reader/writer 200. The control device 500 manages tag information collected from the reader/writer 200, and transmits the tag information to another device as appropriate. The control device 500 includes, for example, a processor, a flash memory, a touchscreen, a communication interface, and the like. The control device 500 is a terminal device such as, for example, a laptop, a tablet terminal, or a smartphone.

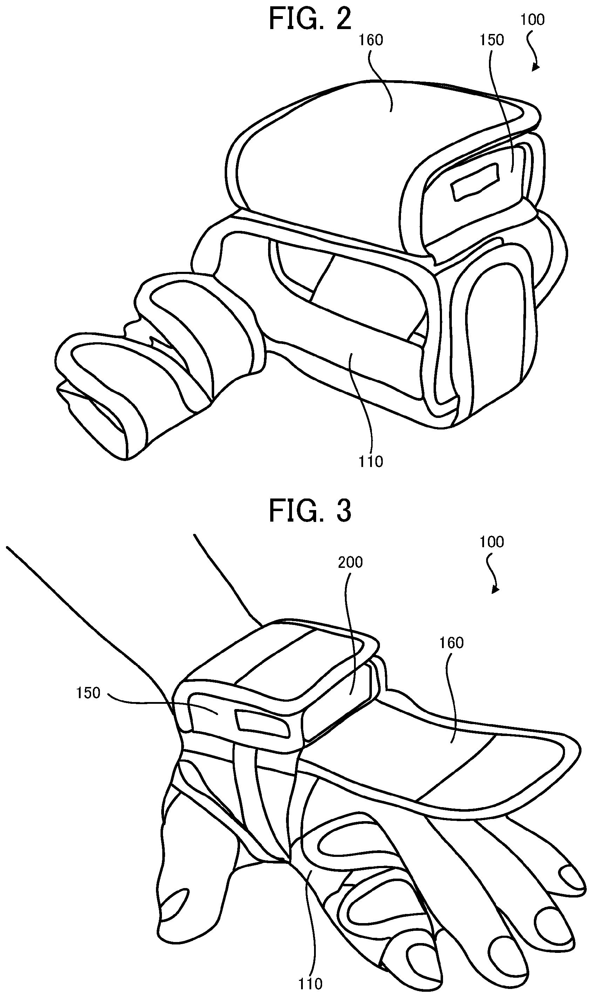

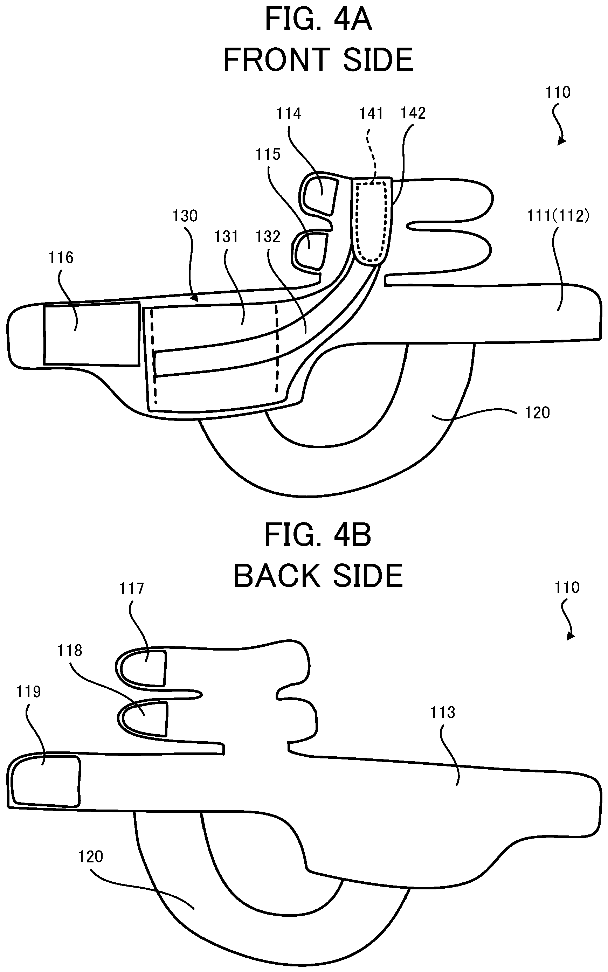

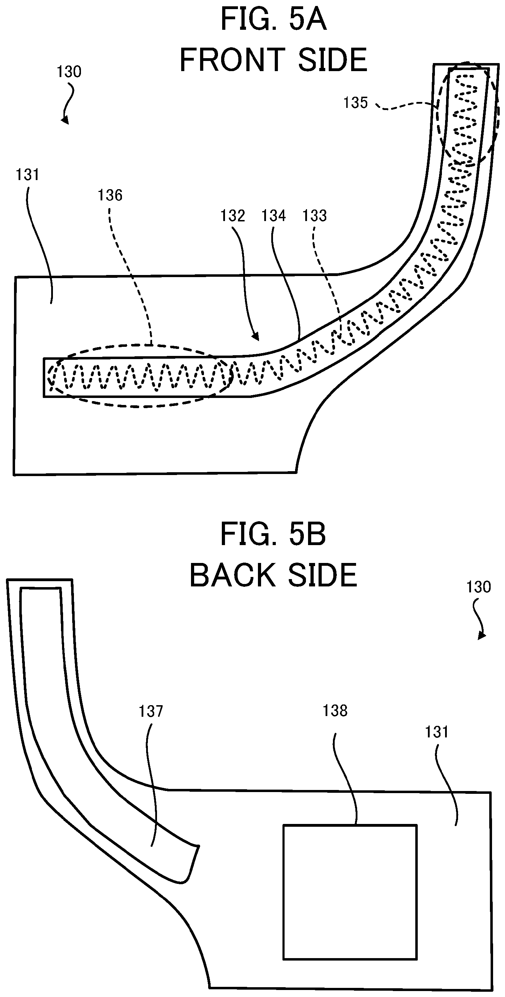

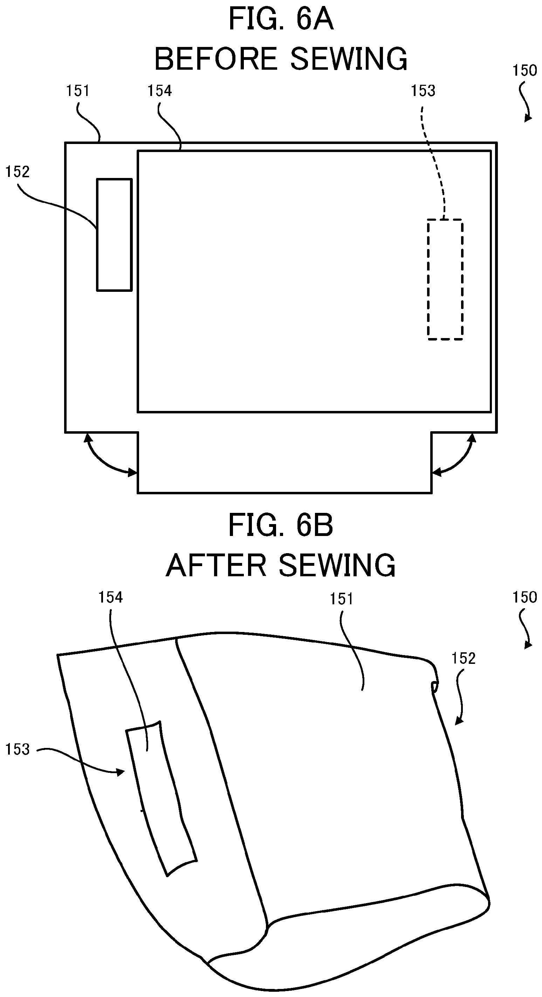

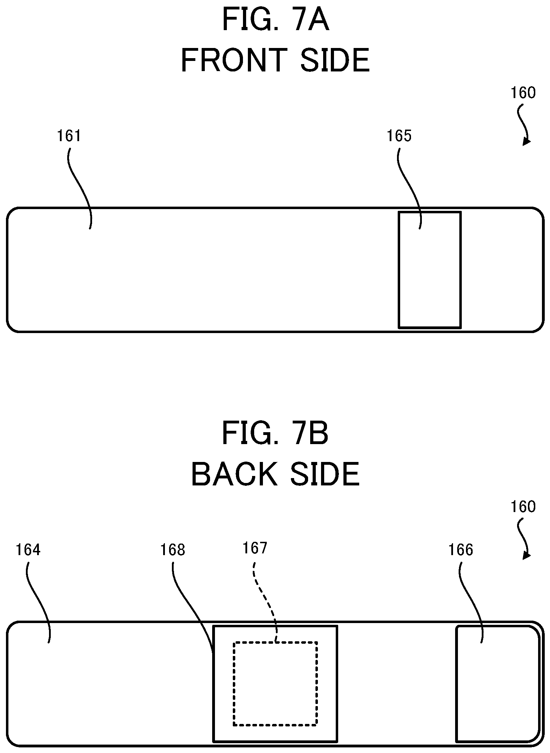

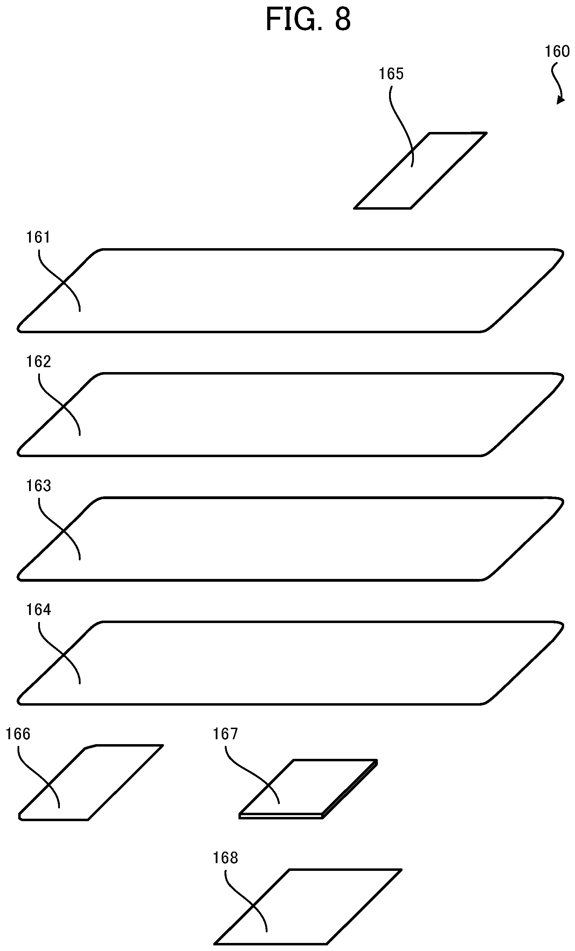

Next, a configuration of the mounting article 100 is described in detail with reference to FIGS. 2 to 8. FIG. 2 is a view illustrating an external appearance of the mounting article 100. FIG. 3 is a view illustrating an external appearance of the mounting article 100 when mounted. FIGS. 4A and 4B are each a view illustrating the mounter 110 of the mounting article 100. FIGS. 5A and 5B are each a view illustrating a ribbon support 130 of the mounting article 100. FIGS. 6A and 6B are each a view illustrating the storage 150 of the mounting article 100. FIGS. 7A and 7B are each a view illustrating the cover 160 of the mounting article 100. FIG. 8 is an exploded perspective view of the cover 160 of the mounting article 100.

As illustrated in FIGS. 2 and 3, the mounting article 100 is an article to be mounted on the left hand of a user. The mounter 110 is fixed to the index finger of the left hand by a hook-and-loop fastener. Further, the mounter 110 is fixed to the back and palm of the left hand by a hook-and-loop fastener and an elastic band. The storage 150 is a pocket storing the reader/writer 200. The storage 150 is fixed to the mounter 110 in such a way as to be arranged on the back of the left hand. The cover 160 is wrapped around the storage 150 in such a way as to cover a part of a surface of the storage 150.

The reader/writer 200 is stored inside the storage 150 fixed to the mounter 110, and is enclosed in the storage 150 by the cover 160. Accordingly, the mounter 110, the storage 150, and the cover 160 have a function of fixing the reader/writer 200 to the back of the left hand of a user. Note that, FIG. 3 illustrates a state where an opening of the storage 150 is not covered by the cover 160 and the reader/writer 200 can be put into and taken out from the storage 150. Further, the mounter 110 has a function of propagating radio waves used by the reader/writer 200. Further, the cover 160 has a function of blocking radio waves not used for communication between the reader/writer 200 and the wireless tag 400.

Next, a configuration of the mounter 110 is described in detail with reference to FIGS. 4A and 4B. FIG. 4A is a view illustrating how a front side of the mounter 110 looks. FIG. 4B is a view illustrating how a back side of the mounter 110 looks. The mounter 110 includes a member 111, a member 112, a member 113, a hook-and-loop fastener 114, a hook-and-loop fastener 115, a hook-and-loop fastener 116, a hook-and-loop fastener 117, a hook-and-loop fastener 118, a hook-and-loop fastener 119, an elastic band 120, the ribbon support 130, a member 141, and a member 142.

The member 111, the member 112, and the member 113 are sheet-shaped members serving as a base to which each member is attached. The sheet shape is a thin and flat shape. When a certain member has a thin and flat shape, the member is sheet-shaped regardless of a shape viewed in plan. The member 111, the member 112, and the member 113 have a shape suitable for being fixed to the index finger of the left hand, the back of the left hand, and the palm of the left hand. The member 111, the member 112, and the member 113 have a similar shape and size in plan view, and are stacked in order and fixed.

Note that, in the present embodiment, a method of fixing each member can be adjusted as appropriate. For example, as the method of fixing each member, sewing with a thread, bonding with an adhesive, bonding with a double-sided tape, and the like are conceivable. Further, although omitted in FIGS. 4A and 4B, edges of the members are covered with various kinds of fabrics.

The front side of the mounter 110 is a side on which a surface of the member 111 is exposed, and the back side of the mounter 110 is a side on which a surface of the member 113 is exposed. In a state where the mounter 110 is mounted on the left hand, basically, the front side of the mounter 110 is a side exposed externally, and the back side of the mounter 110 is a side making contact with a skin. The member 112 is preferably made of a cushioning material. The member 113 is preferably made of a cushioning and non-slip material because the member makes contact with a human body.

The member 111 is made of, for example, a polyester woven fabric using Solotex (registered trademark). Solotex (registered trademark) is a polyester-based stretch fiber that is a composite fiber in which polytrimethylene terephthalate components and polyethylene terephthalate components are bonded side by side. The member 112 is made of, for example, expanded urethane foam, tricot-covered urethane foam, or the like. The member 113 is made of, for example, a double-raschel knitted fabric using Nanofront (registered trademark). Nanofront (registered trademark) is an ultrafine polyester fiber. The member 112 preferably has a thickness of approximately 2 mm. The member 113 preferably has a thickness of approximately 2 mm.

The hook-and-loop fastener 114, the hook-and-loop fastener 115, the hook-and-loop fastener 117, and the hook-and-loop fastener 118 are hook-and-loop fasteners for fixing the mounter 110 to the index finger. The hook-and-loop fastener 116 and the hook-and-loop fastener 119 are hook-and-loop fasteners for fixing the mounter 110 to the back and palm of the hand. The hook-and-loop fastener 114 and the hook-and-loop fastener 117 are detachable, the hook-and-loop fastener 115 and the hook-and-loop fastener 118 are detachable, and the hook-and-loop fastener 116 and the hook-and-loop fastener 119 are detachable.

For example, when the hook-and-loop fastener 114, the hook-and-loop fastener 115, and the hook-and-loop fastener 116 are hook-side hook-and-loop fasteners, the hook-and-loop fastener 117, the hook-and-loop fastener 118, and the hook-and-loop fastener 119 are loop-side hook-and-loop fasteners. The hook-and-loop fastener 114, the hook-and-loop fastener 115, and the hook-and-loop fastener 116 are attached to the surface of the member 111. The hook-and-loop fastener 117, the hook-and-loop fastener 118, and the hook-and-loop fastener 119 are attached to the surface of the member 113. The elastic band 120 is a rubber band for fixing the mounter 110 to the left hand with appropriate force by using the hook-and-loop fastener 116 and the hook-and-loop fastener 119.

The ribbon support 130 is a member to support the conductive ribbon 132. Hereinafter, a configuration of the ribbon support 130 is described in detail with reference to FIGS. 5A and 5B. FIG. 5A is a view illustrating how a front side of the ribbon support 130 looks. FIG. 5B is a view illustrating how a back side of the ribbon support 130 looks. The ribbon support 130 includes a member 131, the conductive ribbon 132, a member 137, and a shielding body 138.

The member 131 is a sheet-shaped member serving as a base to which the conductive ribbon 132 is attached. The member 131 has a shape suitable for wrapping from the back of the left hand to the palm side of the index finger of the left hand. The front side of the member 131 is a side exposed externally, and the back side of the member 131 is a side making contact with the member 111. The member 131 is made of, for example, suede.

The conductive ribbon 132 is a member to propagate radio waves used for reading tag information by the reader/writer 200. The conductive ribbon 132 is a flat and elongated member with conductivity. The conductive ribbon 132 is arranged on the front side of the member 131. The conductive ribbon 132 propagates radio waves used for reading tag information between a reader 135 and an arranger 136. The reader 135 is a part of the conductive ribbon 132 that is brought close to the wireless tag 400 to read tag information. The arranger 136 is a part of the conductive ribbon 132 in which the reader/writer 200 is arranged. The conductive ribbon 132 includes a conductive thread 133 and a member 134.

The conductive thread 133 is a thread-shaped member having conductivity. The conductive thread 133 may be a thread generated by copper-plating twisted fibers, may be a thread generated by twisting copper foil-wrapped fibers, or may be a thread generated by twisting carbon fibers. The member 134 is a member to which the conductive thread 133 is attached. The member 134 is a strip-shaped member having stretchability. The member 134 is made of, for example, rubber.

In the conductive ribbon 132, the conductive thread 133 is arranged in a meander shape. That is, the conductive thread 133 is arranged on the member 134, in a zig-zag way from the reader 135 to the arranger 136. The conductive thread 133 arranged in a meander shape strengthens electromagnetic coupling between the conductive thread 133 and the antenna 270 and reduces leakage of radio waves.

A method of attaching the conductive thread 133 to the member 134 can be adjusted as appropriate. For example, the conductive thread 133 may be attached to the member 134 by sewing the conductive thread 133 per se. Alternately, the conductive thread 133 may be fixed to the member 134 by sewing another thread. Alternately, the conductive thread 133 may be fixed to the member 134 with an adhesive. The reader 135 is one example of the reader. The arranger 136 is one example of the arranger.

The member 137 is a sheet-shaped member for ensuring a distance between the conductive ribbon 132 and the hand of a user. The member 137 is arranged on the back side of the member 131 at a position facing a part of the conductive ribbon 132 other than the arranger 136. The member 137 is made of, for example, high-expanded polyethylene foam. The member 137 preferably has a thickness of approximately 3 mm from a perspective of minimizing attenuation of electromagnetic energy described later.

The shielding body 138 is a sheet-shaped member blocking radio waves. The shielding body 138 is arranged at a position sandwiching the conductive ribbon 132 between the antenna 270 and the shielding body 138. Specifically, the shielding body 138 is arranged on the back side of the member 131 at a position facing the arranger 136. The shielding body 138 has a function of adjusting strength of electromagnetic coupling between the antenna 270 and the conductive ribbon 132. The shielding body 138 is made of, for example, an aluminum-deposited polyvinyl chloride (PVC) sheet. The aluminum-deposited PVC sheet is a film material made by laminating an aluminum-deposited film to a polyester base fabric and coating the aluminum-deposited film and the polyester base fabric with soft polyvinyl chloride. The aluminum-deposited PVC sheet has a radio wave shielding property by including a metal layer. Further, the aluminum-deposited PVC sheet can be sewn due to high strength. Further, the aluminum-deposited PVC sheet conforms well to movement of the fabric making up the mounting device due to flexibility. The shielding body 138 is attached to the member 131 by, for example, sewing. The shielding body 138 is one example of the second shielding body.

The ribbon support 130 is sewn to the member 111 with the back side of the member 131 arranged to overlap the member 111. Herein, the ribbon support 130 is sewn to the member 111 preferably along dashed lines illustrated in FIG. 4A in such a way that the cover 160 can be passed between the member 111 and the member 131.

The member 141 and the member 142 are sheet-shaped members arranged at a position of the ribbon support 130 overlapping the reader 135. The member 141 and the member 142 have a similar shape in plan view. In plan view, the member 142 is slightly larger than the member 141. The member 142 and the member 131 are sewn to each other with the member 141 sandwiched therebetween. The member 141 is made of, for example, polyolefin foam. The member 142 is made of, for example, artificial leather.

Next, the storage 150 is described with reference to FIGS. 6A and 6B. FIG. 6A is a view illustrating the storage 150 before sewing, that is, the storage 150 unshaped by sewing. FIG. 6B is a view illustrating the storage 150 after sewing, that is, the storage 150 shaped by sewing. The storage 150 includes a member 151 and a member 154.

The member 151 is a sheet-shaped member constituting an outer shape of the storage 150. The member 151 includes an open hole 152 and an open hole 153. The open hole 152 is an open hole uncovered by the member 154. The open hole 152 is, for example, an open hole provided in order that a user operates the operation acceptor 240 included in the reader/writer 200 stored in the storage 150. The open hole 152 may be used, for example, in order to connect a universal serial bus (USB) cable to a USB terminal for charging (not illustrated) included in the reader/writer 200.

The open hole 153 is an open hole covered by the member 154. The open hole 153 is, for example, an open hole provided in order that a user visually recognizes the display 230 included in the reader/writer 200 stored in the storage 150. The member 151 is preferably made of a material durable enough to maintain shapes of an open hole (not illustrated) of the storage 150 for putting into and taking out the reader/writer 200, the open hole 152, the open hole 153, and the like. The member 151 is made of, for example, artificial leather.

The member 154 is a transparent sheet-shaped member superimposed on the member 151. The member 154 is provided in order to prevent distortion of the open hole 153. The member 154 is sewn to the member 151 while being superimposed on the member 151 in such a way as not to cover the open hole 152 but to cover the open hole 153. The member 154 is made of, for example, a PVC sheet that is a sheet of transparent soft polyvinyl chloride.

The storage 150 before sewing illustrated in FIG. 6A is folded at a left-side edge, a lower-side edge, and a right-side edge in such a way that a surface with the member 154 faces outward, then a lower edge of the left-side edge and a left edge of the lower-side edge are sewn to each other, and a lower edge of the right-side edge and a right edge of the lower-side edge are sewn to each other. Thereafter, the storage 150 is turned over in such a way that a surface with the member 151 faces outward, and the storage 150 after sewing illustrated in FIG. 6B is completed. The completed storage 150 is attached to the mounter 110. Specifically, for example, the storage 150 is sewn to the ribbon support 130 while the storage 150 is superimposed on a position of the ribbon support 130 corresponding to the arranger 136 in such a way that the member 154 faces the ribbon support 130.

Next, the cover 160 is described with reference to FIGS.7A, 7B and 8. FIG. 7A is a view illustrating how a front side of the cover 160 looks. FIG. 7B is a view illustrating how a back side of the cover 160 looks. FIG. 8 is an exploded perspective view of the cover 160. The cover 160 includes a member 161, a shielding body 162, a member 163, a member 164, a hook-and-loop fastener 165, a hook-and-loop fastener 166, a member 167, and a member 168.

The member 161 and the member 164 are sheet-shaped members serving as a base to which each member is attached. The shielding body 162 is a member to block radio waves unnecessary for reading tag information by the reader/writer 200. The member 163 is a sheet-shaped member for ensuring a distance between the conductive ribbon 132 and the shielding body 162. The member 161, the shielding body 162, the member 163, and the member 164 have a similar shape and size in plan view. The member 161, the shielding body 162, the member 163, and the member 164 are stacked in order and fixed. Note that, although omitted in FIGS. 7 and 8, edges of the members are covered with various kinds of fabrics.

The front side of the cover 160 is a side on which a surface of the member 161 is exposed, and the back side of the cover 160 is a side on which a surface of the member 164 is exposed. In a state where the cover 160 is wrapped around the storage 150, basically, the front side of the cover 160 is an outer side, and the back side of the cover 160 is an inner side. The member 161 is made of, for example, a polyester woven fabric using Solotex (registered trademark). The shielding body 162 is made of, for example, aluminum-deposited PVC. The member 163 is made of, for example, expanded urethane foam, tricot-covered urethane foam, or the like. The member 164 is made of, for example, a polyester woven fabric using Solotex (registered trademark). The member 163 preferably has a thickness of approximately 2 mm from a perspective of a distance between the shielding body 162 and the conductive ribbon 132 described later. The shielding body 162 is one example of the first shielding body.

The hook-and-loop fastener 165 and the hook-and-loop fastener 166 are hook-and-loop fasteners for wrapping and fixing the cover 160 around the storage 150. The hook-and-loop fastener 165 and the hook-and-loop fastener 166 are detachable, and, when the hook-and-loop fastener 165 is a hook-side hook-and-loop fastener, the hook-and-loop fastener 166 is a loop-side hook-and-loop fastener. The hook-and-loop fastener 165 is attached to the surface of the member 161. The hook-and-loop fastener 166 is attached to the surface of the member 164.

The member 167 is a sheet-shaped member for ensuring a distance between the conductive ribbon 132 and the shielding body 162. The member 168 is a sheet-shaped member for attaching the member 167 to the member 164. In plan view, the member 167 is larger than the member 168. The member 167 is fixed to the surface of the member 164 by sewing edges of the member 168 to the member 164 with the member 167 sandwiched between the member 164 and the member 168. The member 167 is made of, for example, expanded polyethylene foam. The member 168 is made of, for example, a double-raschel knitted fabric using Nanofront (registered trademark). The member 167 preferably has a thickness of approximately 5 mm from a perspective of a distance between the shielding body 162 and the conductive ribbon 132 described later.

The cover 160 is attached to the storage 150 attached to the mounter 110. Specifically, the cover 160 is put between the ribbon support 130 and the member 111 of the mounter 110, and is fixed to the mounter 110 with the member 167 of the cover 160 overlapping the arranger 136 of the mounter 110.

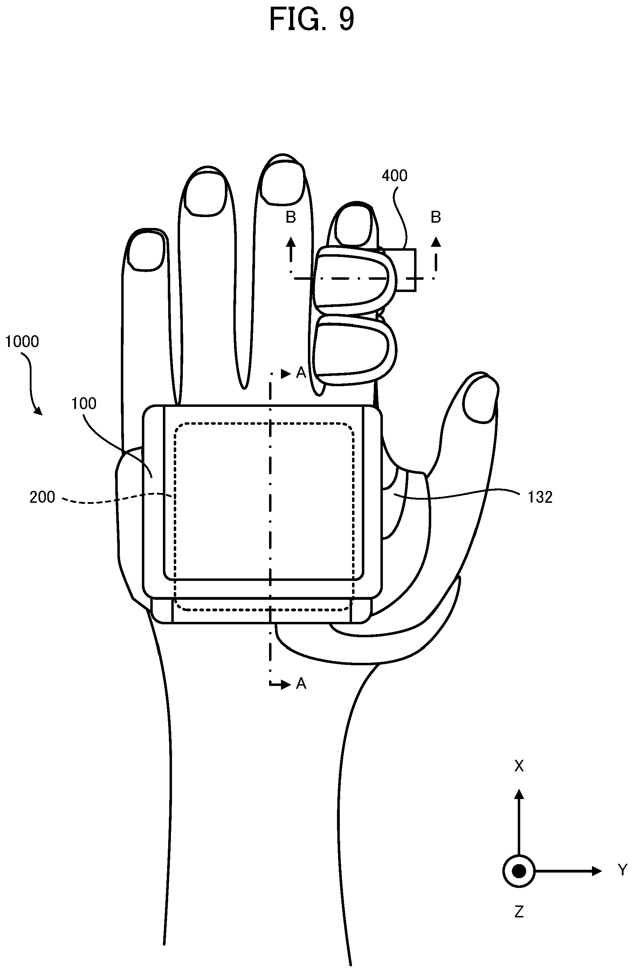

Next, a method of reading tag information from the wireless tag 400 by using the reading system 1000 is described with reference to FIG. 9. In FIG. 9, a Z-axis is an axis extending in a vertical direction, an X-axis is an axis perpendicular to the Z-axis, and a Y-axis is an axis perpendicular to the X-axis and the Z-axis. A direction in which an arrow of the X-axis extends is a positive direction of the X-axis, and a direction opposite to the direction in which the arrow of the X-axis extends is a negative direction of the X-axis. A direction in which an arrow of the Y-axis extends is a positive direction of the Y-axis, and a direction opposite to the direction in which the arrow of the Y-axis extends is a negative direction of the Y-axis. A direction in which an arrow of the Z-axis extends is a positive direction of the Z-axis, and a direction opposite to the direction in which the arrow of the Z-axis extends is a negative direction of the Z-axis. Hereinafter, the positive direction of the Z-axis is referred to as an upward direction, and the negative direction of the Z-axis is referred to as a downward direction as appropriate.

First, a user attaches the reader/writer 200 to the mounting article 100. Specifically, the user puts the reader/writer 200 into the storage 150 and attaches the hook-and-loop fastener 166 to the hook-and-loop fastener 165, thereby covering the storage 150 with the cover 160. Then, the user mounts the mounting article 100 on his/her left hand. Specifically, with the back and palm of the left hand wrapped with the member 113, the user attaches the hook-and-loop fastener 119 to the hook-and-loop fastener 116, thereby fixing the mounting article 100 on the back and palm of the left hand. Further, with the index finger of the left hand wrapped with the member 113, the user attaches the hook-and-loop fastener 117 to the hook-and-loop fastener 114 and attaches the hook-and-loop fastener 118 to the hook-and-loop fastener 115, thereby fixing the mounting article 100 to the index finger of the left hand.

Then, the user powers on the reader/writer 200. Thereafter, the reader/writer 200 starts reading tag information, and regularly emits radio waves for power supply. Herein, when the user brings the index finger of the left hand close to the wireless tag 400, the reader/writer 200 reads tag information from the wireless tag 400.

Specifically, the reader/writer 200 emits radio waves for power supply from the antenna 270. Then, electromagnetic energy corresponding to the radio waves for power supply emitted from the antenna 270 is supplied to the arranger 136 of the conductive ribbon 132 by electric field coupling, magnetic field coupling, radio wave transmission and reception, or a combination thereof. The electromagnetic energy supplied to the arranger 136 of the conductive ribbon 132 is propagated to the reader 135 of the conductive ribbon 132.

The electromagnetic energy propagated to the reader 135 of the conductive ribbon 132 is supplied to the antenna 440 included in the wireless tag 400 by electric field coupling, magnetic field coupling, radio wave transmission and reception, or a combination thereof. The wireless tag 400 is activated by the electromagnetic energy received from the conductive ribbon 132, and emits tag information-containing radio waves from the antenna 440. Electromagnetic energy corresponding to the radio waves for power supply emitted from the antenna 440 is supplied to the reader 135 of the conductive ribbon 132 by electric field coupling, magnetic field coupling, radio wave transmission and reception, or a combination thereof.

The electromagnetic energy supplied to the reader 135 of the conductive ribbon 132 is propagated to the arranger 136 of the conductive ribbon 132. The electromagnetic energy propagated to the arranger 136 of the conductive ribbon 132 is supplied to the antenna 270 by electric field coupling, magnetic field coupling, radio wave transmission and reception, or a combination thereof. The electromagnetic energy supplied to the antenna 270 is supplied to a demodulation circuit (not illustrated) as a high-frequency signal including tag information. The demodulation circuit demodulates the supplied high-frequency signal and acquires tag information. The tag information acquired by the demodulation circuit is supplied to the controller 210.

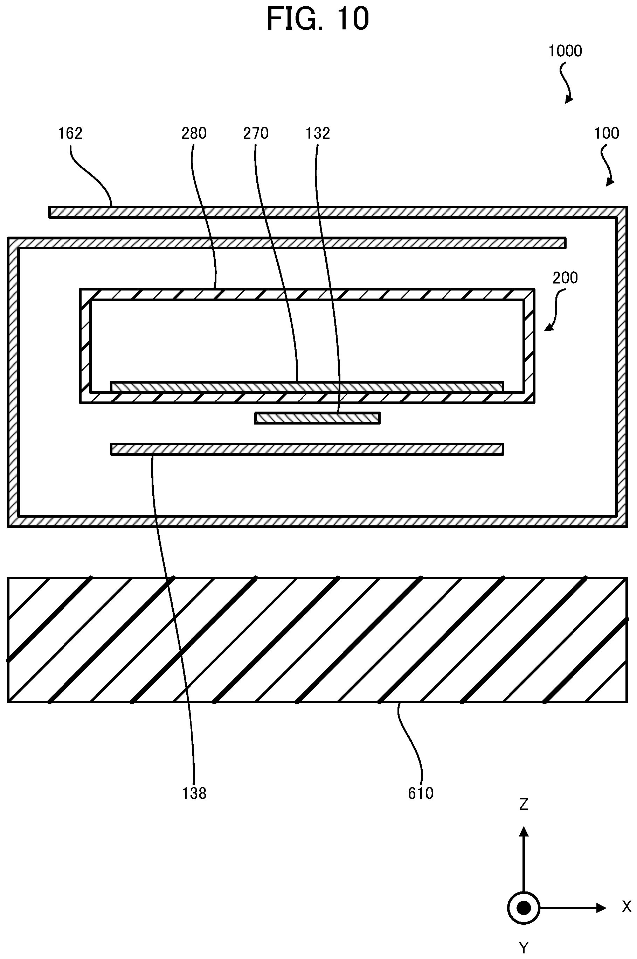

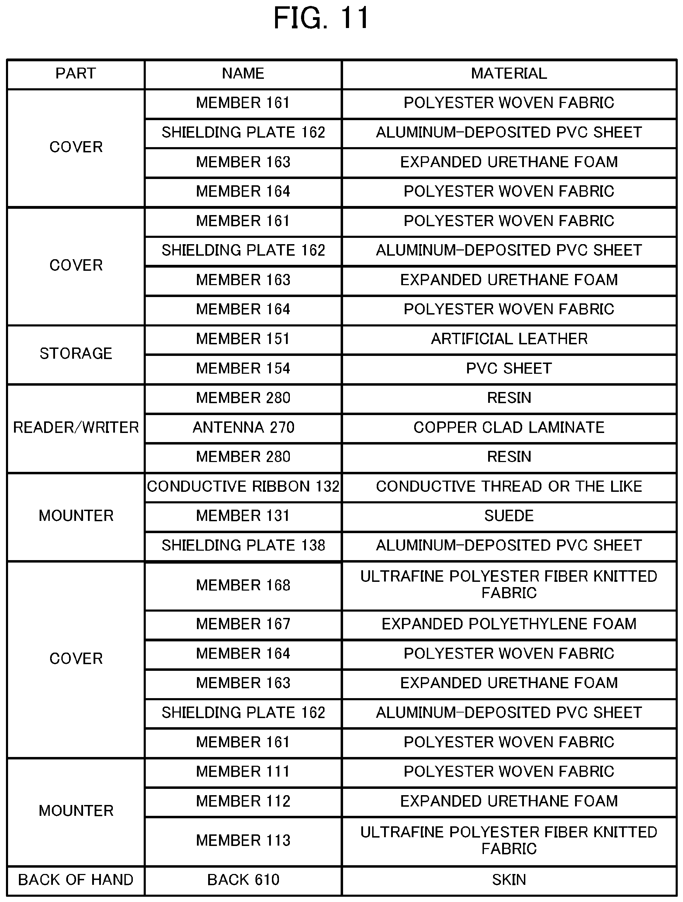

Herein, a structure for improving accuracy in reading tag information is adopted for the mounting article 100. Hereinafter, a structure around the arranger 136 of the mounting article 100 is described. FIG. 10 illustrates a sectional view along a line A-A in FIG. 9. In FIG. 10, for ease of understanding, illustration of a member having little influence on radio waves is omitted as appropriate. Note that, FIG. 11 illustrates arrangement order, materials, and the like of the members present on a cross section of the A-A line. In FIG. 10, a back (of the hand) 610 is the back of the left hand of a user.

The antenna 270 included in the reader/writer 200 is arranged inside a housing 280 included in the reader/writer 200 in such a way as to face the conductive ribbon 132. The shielding body 162 included in the cover 160 is wrapped about an axis extending in the Y-axis direction in such a way as to cover the antenna 270, the conductive ribbon 132, and the shielding body 138 together. Further, the shielding body 138 included in the mounter 110 is arranged to face the conductive ribbon 132 in such a way as to sandwich the conductive ribbon 132 between the shielding body 138 and the antenna 270.

The shielding body 162 blocks transmission of electromagnetic energy to another wireless tag, and shields transmission of electromagnetic energy from another wireless tag to the antenna 270. Hereinafter, a reason therefor is described. Note that, another wireless tag is a wireless tag not subject to reading tag information. Meanwhile, the wireless tag 400 is a wireless tag subject to reading tag information. First, the shielding body 162 is arranged in any direction of the positive direction of the X-axis, the negative direction of the X-axis, the positive direction of the Z-axis, and the negative direction of the Z-axis as seen from the antenna 270. Accordingly, when another wireless tag is arranged in the directions, the shielding body 162 blocks transmission of electromagnetic energy.

In particular, the shielding body 162 is arranged in two layers in the positive direction of the Z-axis as seen from the antenna 270. Accordingly, reading tag information from another wireless tag arranged in the positive direction of the Z-axis as seen from the antenna 270 can be sufficiently prevented. Meanwhile, the back of the hand of the user is arranged in the negative direction of the Z-axis as seen from the antenna 270. Accordingly, reading tag information from another wireless tag arranged in the negative direction of the Z-axis as seen from the antenna 270 can also be sufficiently prevented.

Further, the antenna 270 spreads in a direction perpendicular to the Z-axis direction, and thus, is less likely to emit radio waves in any direction of the positive direction of the X-axis, the negative direction of the X-axis, the positive direction of the Y-axis, and the negative direction of the Y-axis. Accordingly, even if another wireless tag is arranged in the positive direction of the Y-axis and the negative direction of the Y-axis as seen from the antenna 270, electromagnetic energy is less likely to be transmitted from the antenna 270 to the another wireless tag.

Meanwhile, the shielding body 162 does not block transmission of electromagnetic energy to the wireless tag 400 that is a wireless tag subject to reading tag information, and does not shield the antenna 270 from the wireless tag 400. Hereinafter, a reason therefor is described. First, the reader/writer 200 transmits, by using the antenna 270, electromagnetic energy to the antenna 440 included in the wireless tag 400 via the conductive ribbon 132.

Herein, the shielding body 162 is wrapped in such a way as to cover the antenna 270 and the conductive ribbon 132 together, and is not arranged on a transmission path of electromagnetic energy from the antenna 270 to the antenna 440. Accordingly, the shielding body 162 does not block transmission of electromagnetic energy from the antenna 270 to the antenna 440. Thus, the present embodiment enables pinpoint reading, that is, reading tag information from only the wireless tag 400. Note that, the shielding body 162 is arranged in such a way as not to cover the entire reader/writer 200. Accordingly, the shielding body 162 does not disrupt wireless communication between the reader/writer 200 and the control device 500.

Herein, when a distance between the shielding body 162 and the antenna 270 is too close, impedance matching for the antenna 270 may not be achieved, resulting in decreased coupling efficiency between the antenna 270 and the conductive ribbon 132. In view of this, a distance between the shielding body 162 and the conductive ribbon 132 is preferably not too close. For example, the distance between the shielding body 162 and the conductive ribbon 132 is preferably 9 mm or more.

Further, the shielding body 138 is provided in order to adjust strength of electromagnetic coupling between the antenna 270 and the arranger 136 of the conductive ribbon 132. Herein, a reason why the shielding body 138 is necessary is described. When the electromagnetic coupling between the antenna 270 and the arranger 136 is too weak, reading tag information from the wireless tag 400 arranged near the reader 135 of the conductive ribbon 132 is difficult.

Meanwhile, when the electromagnetic coupling between the antenna 270 and the arranger 136 is too strong, electromagnetic energy may be emitted from the conductive ribbon 132 into space, resulting in erroneous reading of tag information. For example, when the electromagnetic coupling is too strong, tag information may be read erroneously from another wireless tag arranged near a middle part of the conductive ribbon 132. The middle part is a part between the arranger 136 and the reader 135 of the conductive ribbon 132. Herein, strength of radio waves emitted by the reader/writer 200 from the antenna 270 often cannot be adjusted precisely. In view of this, the electromagnetic coupling between the antenna 270 and the arranger 136 is preferably weakened by the shielding body 138 appropriately.

The shielding body 138 is arranged in parallel to the arranger 136 in such a way as to face the arranger 136 of the conductive ribbon 132. Herein, the shorter a distance between the shielding body 138 and the arranger 136, the weaker the electromagnetic coupling between the antenna 270 and the arranger 136. In view of this, the electromagnetic coupling is preferably weakened appropriately by appropriately adjusting the distance between the shielding body 138 and the arranger 136. Note that, instead of arranging the shielding body 138 near the arranger 136, there is a method of bringing the shielding body 162 close to the arranger 136. In the method, a distance between the shielding body 162 and the arranger 136 may vary, and thus, adjusting strength of the electromagnetic coupling between antenna 270 and the arranger 136 may not be easy.

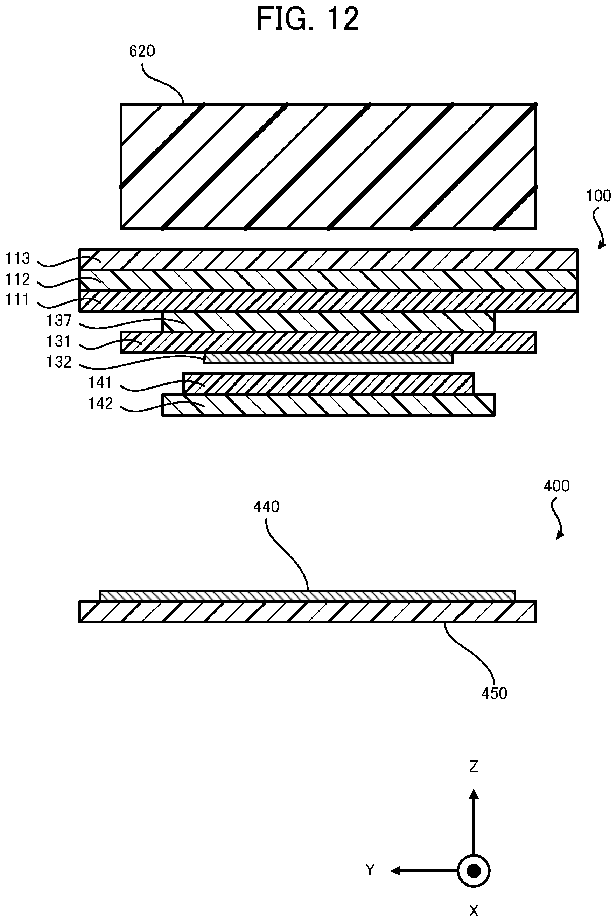

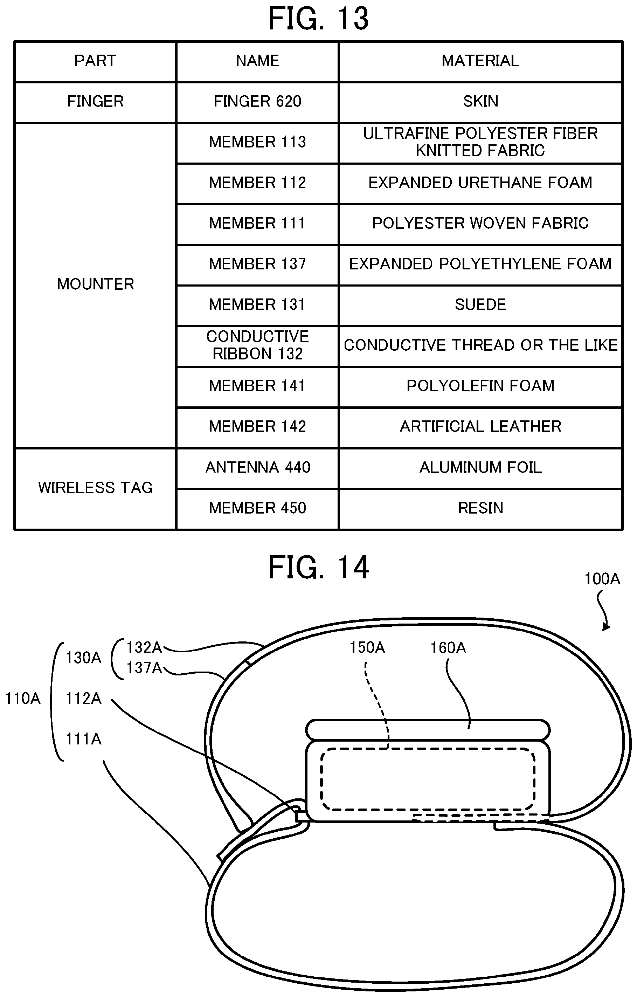

Next, a structure around the reader 135 of the mounting article 100 is described. FIG. 12 illustrates a sectional view along a line B-B in FIG. 9. In FIG. 12, for ease of understanding, only members arranged below a finger 620 that is the index finger of the left hand of a user are illustrated. Note that, FIG. 13 indicates arrangement order, materials, and the like of the members present on a cross section of the B-B line.

When reading tag information, the user brings the index finger of the left hand close to the wireless tag 400 in such a way that the reader 135 of the conductive ribbon 132 faces the antenna 440 of the wireless tag 400. This enables transmission of electromagnetic energy between the reader 135 and the antenna 440, enabling reading of tag information.

Herein, when a human body or an object is present near the conductive ribbon 132, electromagnetic energy propagating in the vicinity of the conductive ribbon 132 propagates within the human body or within the object. In this case, the electromagnetic energy is attenuated due to electrical characteristics of the human body or the object, that is, permittivity of the human body or the object and dielectric loss caused by dielectric loss tangent. The greater the permittivity and the dielectric loss tangent, the greater a degree of the attenuation. Accordingly, in order to minimize attenuation of the electromagnetic energy, the human body having relatively large permittivity and dielectric loss tangent and the object having large permittivity and dielectric loss tangent are desirably not arranged near the conductive ribbon 132.

In view of the above, in the present embodiment, a member having small permittivity and dielectric loss tangent and having a certain degree of thickness is arranged between the conductive ribbon 132 and the human body. Such a member is preferably made of a material having small permittivity and dielectric loss tangent and has a structure having small permittivity and dielectric loss tangent. The material having small permittivity and dielectric loss tangent is polyolefin, polyester, or the like. The structure having small permittivity and dielectric loss tangent is a three-dimensional structure represented by a double-raschel knitted structure, a porous structure, or the like.

In the present embodiment, the member 113, the member 137, and the like are provided as such members, and thus, attenuation of the electromagnetic energy caused by the human body, the member 113, the member 137, and the like can be minimized. A distance between the conductive ribbon 132 and the human body is preferably 3 mm or more.

In the present embodiment, the cover 160 covering the storage 150 includes the shielding body 162 having a sheet shape and configured to cover at least one full periphery of the storage 150. The shielding body 162 prevents reading tag information from another wireless tag not subject to reading tag information. Accordingly, the present embodiment has high accuracy in reading tag information.

Further, in the present embodiment, the shielding body 162 is arranged in two layers on an opposite side from a body part of a user as seen from the reader/writer 200. Accordingly, the present embodiment sufficiently prevents reading tag information from another wireless tag arranged on an opposite side from a body part of a user as seen from the reader/writer 200.

Further, in the present embodiment, the cover 160 is arranged in such a way that the shielding body 162 covers the storage 150 and the arranger 136 of the conductive ribbon 132 together. Accordingly, the present embodiment can prevent reading tag information from another wireless tag while maintaining reading tag information from the wireless tag 400.

Further, in the present embodiment, the mounter 110 includes the shielding body 138 having a sheet shape and arranged in such a way as to sandwich the arranger 136 of the conductive ribbon 132 between the shielding body 138 and the reader/writer 200. The shielding body 138 adjusts strength of electromagnetic coupling between the arranger 136 and the antenna 270. Accordingly, the present embodiment can prevent reading tag information from another wireless tag while maintaining reading tag information from the wireless tag 400.

Further, in the present embodiment, the cover 160 is arranged in such a way that the shielding body 162 covers the storage 150, the arranger 136 of the conductive ribbon 132, and the shielding body 138 together. Accordingly, the present embodiment can prevent reading tag information from another wireless tag while maintaining reading tag information from the wireless tag 400.

Further, in the present embodiment, the shielding body 162 is wrapped in such a way as not to cover lateral sides of the storage 150. Accordingly, the present embodiment enables operation on the operation acceptor 240 via the open hole 152, charging via the open hole 152, wireless communication between the reader/writer 200 and the control device 500, checking the display 230 via the open hole 153, and the like in a state where the reader/writer 200 is stored in the storage 150.

Further, in the present embodiment, the conductive thread 133 is arranged in a meander shape. Accordingly, the present embodiment reduces emission of radio waves from the conductive thread 133 at a middle part between the reader 135 and the arranger 136 due to strong electromagnetic coupling between the conductive thread 133 and the antenna 270.

Further, in the present embodiment, a distance between the conductive thread 133 and a human body is 3 mm or more. Accordingly, the present embodiment reduces propagation loss caused by the human body.

Further, in the present embodiment, a distance between the conductive thread 133 and the shielding body 162 is 9 mm or more. Accordingly, the present embodiment prevents decrease in coupling efficiency between the conductive thread 133 and the antenna 270, and reduces decrease in accuracy in reading tag information.

Further, in the present embodiment, the member 113 making contact with a human body is made of a double-raschel knitted ultrafine polyester fiber having high static friction resistance. Accordingly, the present embodiment can prevent positional deviation of the reader 135, positional deviation of the reader/writer 200, and the like, thereby enhancing operability, comfort, and the like during operation.

Further, in the present embodiment, the mounting article 100 is mounted on a non-dominant hand. Accordingly, the present embodiment enables a dominant hand to perform another task.

Further, in the present embodiment, tag information can be read by merely putting the reader/writer 200 into the storage 150 of the mounting article 100 without necessity of connection by a connector. That is, in the present embodiment, attaching the reader/writer 200 to the mounting article 100 and detaching the reader/writer 200 from the mounting article 100 are easy. Accordingly, the present embodiment reduces, for example, labor in washing the mounting article 100.

### Embodiment 2

In Embodiment 1, an example in which the storage 150 is arranged on the back of a hand of a user has been described. In the present embodiment, an example in which a storage 150A is arranged on a wrist of a user is described. Hereinafter, description of configurations or functions similar to Embodiment 1 is omitted or simplified as appropriate.

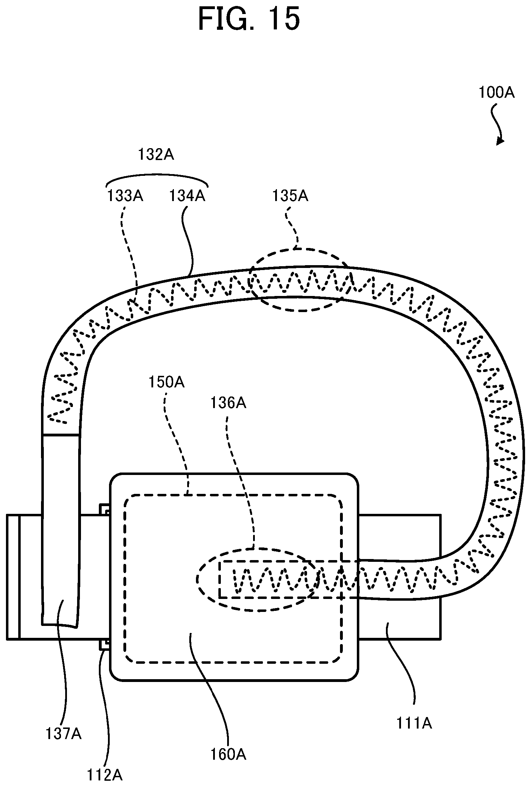

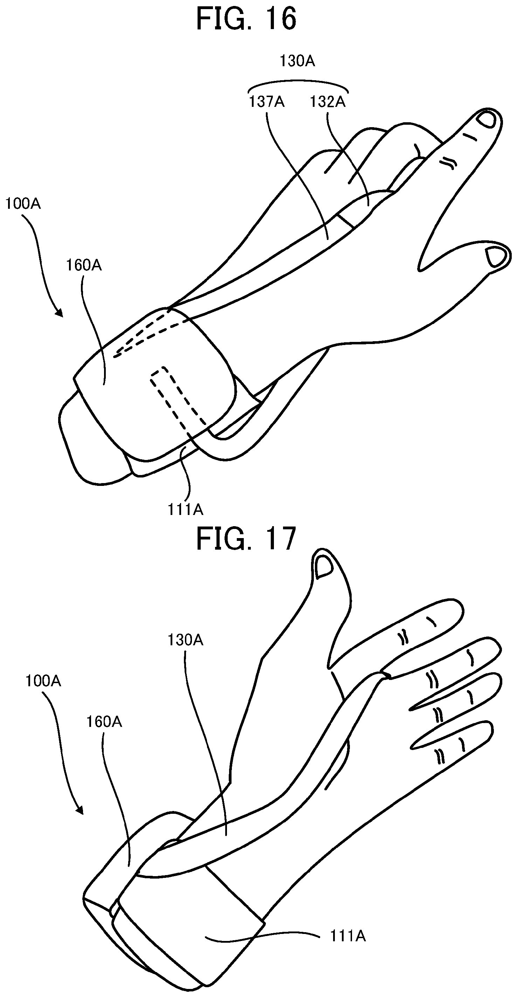

FIG. 14 illustrates a side view of a mounting article 100A according to the present embodiment. FIG. 15 illustrates a top view of the mounting article 100A according to the present embodiment. FIG. 16 illustrates a first external view of the mounting article 100A according to the present embodiment when mounted. FIG. 17 illustrates a second external view of the mounting article 100A according to the present embodiment when mounted. The external view illustrated in FIG. 16 is an external view of the mounting article 100A mounted on a hand of a user as seen from a back side of the hand of the user. The external view illustrated in FIG. 17 is an external view of the mounting article 100A mounted on a hand of a user as seen from a palm side of the user.

The mounting article 100A is an article to be mounted on a body part of a user and for fixing a reader/writer 200 to a body part of a user. The mounting article 100A has a function of storing the reader/writer 200 and a function of propagating radio waves used by the reader/writer 200. The mounting article 100A includes a mounter 110A, the storage 150A, and a cover 160A.

The mounter 110A is a member to be mounted on a body part of a user. In the present embodiment, the mounter 110A is mounted on a non-dominant hand of a user. The mounter 110A includes a member 111A, a metal fitting 112A, and a ribbon 130A.

The member 111A is a strip-shaped member for fixing the storage 150A to a wrist of a user. One end of the member 111A is fixed to one end of a bottom surface of the cover 160A. The other end of the member 111A is fixed to the other end of the member 111A while being put through a slit-shaped open hole (not illustrated) included in the metal fitting 112A. For example, the other end of the member 111A is fixed by a pair of hook-and-loop fasteners (not illustrated) arranged on one side of the member 111A at the other end.

The metal fitting 112A is a metal fitting for fixing the another end of the member 111A to another end of the bottom surface of the cover 160A. The metal fitting 112A is fixed to the another end of the bottom surface of the cover 160A. The metal fitting 112A includes the slit-shaped open hole through which the member 111A is put.

The ribbon 130A is a strip-shaped member for enhancing a degree of freedom in a position of reading tag information. The ribbon 130A is fixed to a body of a user as appropriate in such a way that tag information can be read at a part desired by the user. For example, the ribbon 130A is hooked between fingers of a user when the mounting article 100A is mounted. The ribbon 130A may be hooked between any of the fingers. In the present embodiment, the ribbon 130A is hooked between index and middle fingers. In this case, tag information can be read at a part connecting from between index and middle fingers to a wrist on a palm. When the ribbon 130A is hooked between fingers, the ribbon 130A is fixed to a hand of a user and a position of reading tag information is determined. Note that, the ribbon 130A may not be hooked between fingers. For example, the ribbon 130A may be superimposed on the cover 160A and wrapped around a wrist.

One end of the ribbon 130A is fixed to a bottom of the storage 150A. Another end of the ribbon 130A is fixed to another side of the member 111A at the another end. For example, a hook-and-loop fastener (not illustrated) arranged on one side of the ribbon 130A at the another end and a hook-and-loop fastener (not illustrated) arranged on the another side of the member 111A at the another end are fixed to each other.

The ribbon 130A includes a conductive ribbon 132A and a non-conductive ribbon 137A. The conductive ribbon 132A is a member to propagate radio waves used for reading tag information by the reader/writer 200. The conductive ribbon 132A is a flat and elongated member with conductivity. The conductive ribbon 132A propagates radio waves used for reading tag information between a reader 135A and an arranger 136A. The reader 135A is a part of the conductive ribbon 132A that is brought close to a wireless tag 400 to read tag information. The arranger 136A is a part of the conductive ribbon 132A in which the reader/writer 200 is arranged. The ribbon 130A is one example of the strip-shaped member.

The conductive ribbon 132A includes a conductive thread 133A and a member 134A. The conductive thread 133A is, basically, a member similar to the conductive thread 133. That is, the conductive thread 133A is a thread-shaped member having conductivity. The member 134A is, basically, a member similar to the member 134. That is, the member 134A is a strip-shaped member to which the conductive thread 133A is attached. In the conductive ribbon 132A, the conductive thread 133A is arranged in a meander shape. The conductive ribbon 132A is one example of the propagator.

The non-conductive ribbon 137A is a flat and elongated member without conductivity. In the present embodiment, the non-conductive ribbon 137A is a strip-shaped stretch member having stretchability. By the non-conductive ribbon 137A having stretchability, the ribbon 130A is securely fixed to a hand of a user. The non-conductive ribbon 137A is made of, for example, rubber. The non-conductive ribbon 137A is one example of the stretch member. Note that, the non-conductive ribbon 137A may be a member having no stretchability. For example, the non-conductive ribbon 137A may be a fabric having no stretchability. Further, the non-conductive ribbon 137A may be a hook-and-loop fastener for fixing the ribbon 130A.

As described above, the mounter 110A has a fixing function of fixing the storage 150A and a propagating function of propagating radio waves. Note that, the fixing function is mainly achieved by the member 111A. Further, the propagating function may be achieved by the ribbon 130A including the conductive ribbon 132A. The mounter 110A is one example of the mounter.

The storage 150A basically has configurations and functions similar to the storage 150. That is, the storage 150A is a member fixed to the mounter 110A and configured to store the reader/writer 200 to read tag information of the wireless tag 400. The storage 150A is arranged on a wrist of a user when the mounting article 100A is mounted. The storage 150A is one example of the storage.

The cover 160A basically has configurations and functions similar to the cover 160. That is, the cover 160A is a member to cover the storage 150A. The cover 160A includes a first shielding body (not illustrated) having a sheet shape and configured to cover the storage 150A, similarly to the cover 160. Further, the mounter 110A includes a second shielding body (not illustrated), similarly to the mounter 110. The second shielding body has a sheet shape and is arranged in such a way as to sandwich the arranger 136A between the second shielding body and the reader/writer 200. The cover 160A is arranged in such a way that the first shielding body covers the storage 150A, the arranger 136A, and the second shielding body together. The cover 160A is one example of the cover.

In the present embodiment, basically, an advantageous effect similar to Embodiment 1 can be obtained. For example, in the present embodiment, the cover 160A covering the storage 150A includes a first shielding body having a sheet shape and configured to cover at least one full periphery of the storage 150A. Accordingly, the present embodiment has high accuracy in reading tag information.

Further, in the present embodiment, the mounter 110A includes the ribbon 130A having a strip shape and including the conductive ribbon 132A. The present embodiment can enhance a degree of freedom in a position of reading tag information.

Further, in the present embodiment, the ribbon 130A is hooked between fingers of a user when the mounting article 100A is mounted. The present embodiment appropriately fixes the ribbon 130A to a hand of a user and determines a position of reading tag information.

Further, in the present embodiment, the ribbon 130A includes the non-conductive ribbon 137A functioning as a stretch member having stretchability. The present embodiment fixes the ribbon 130A securely to a hand of a user due to stretchability of the non-conductive ribbon 137A.

### Modification Example

Although the embodiments have been described above, modifications and applications in various forms are possible. Any part of the configurations, functions, and operations described in the above embodiments may be adopted. Further, further configurations, functions, and operations may be adopted in addition to the above-described configurations, functions, and operations. Further, the configurations, functions, and operations described in the above embodiments can be freely combined. Further, the number of components described in the above-described embodiments can be adjusted as appropriate. Further, it is obvious that the materials, sizes, electrical characteristics, and the like that can be adopted are not limited to those indicated in the above embodiments.

In Embodiment 1, an example in which the mounter 110, the storage 150, and the cover 160 are clearly distinguished has been described. Some or all of the mounter 110, the storage 150, and the cover 160 may be integrated, as long as the mounting article 100 as a whole has the function of the mounter 110, the function of the storage 150, and the function of the cover 160.

In Embodiment 1, an example in which the mounting article 100 is mounted on the left hand of a user has been described. The mounting article 100 may be mounted on the right hand of a user, or may be mounted on a part other than a hand of a user. For example, the mounting article 100 may be mounted on a foot of the user.

### Reference Signs List

100, 100A Mounting article
110, 110A Mounter
111, 111A, 112, 113, 131, 134, 134A, 137, 141, 142, 151, 154, 161, 163, 164, 167, 168 Member
114, 115, 116, 117, 118, 119, 165, 166 Hook-and-loop fastener
112A Metal fitting
120 Elastic band
130 Ribbon support
130A Ribbon
132, 132A Conductive ribbon
133, 133A Conductive thread
135, 135A Reader
136, 136A Arranger
137A Non-conductive ribbon
138, 162 Shielding body
150, 150A Storage
152, 153 Open hole
160, 160A Cover
200 Reader/writer
210, 410 Controller
220, 420 Memory
230 Display
240 Operation acceptor
250, 260, 430 Communicator
270, 440 Antenna
280 Housing
400 Wireless tag
500 Control device
610 Back (of hand)
620 Finger
1000 Reading system

## Claims

1. A mounting article comprising:
a mounter to be mounted on a body part of a user;
a storage fixed to the mounter and configured to store a reading device to read tag information of a wireless tag; and
a cover to cover the storage, wherein
the mounter includes a propagator including a reader brought close to the wireless tag and an arranger in which the reading device is arranged, the propagator being configured to propagate radio waves used for reading the tag information, and
the cover includes a first shielding body having a sheet shape and configured to cover at least one full periphery of the storage.

2. The mounting article according to claim 1, wherein the first shielding body is arranged in two layers on an opposite side from the body part of the user as seen from the reading device.

3. The mounting article according to claim 1 or 2, wherein the cover is arranged in such a way that the first shielding body covers the storage and the arranger of the propagator together.

4. The mounting article according to claim 1 or 2, wherein the mounter includes a second shielding body having a sheet shape and arranged in such a way as to sandwich the arranger of the propagator between the second shielding body and the reading device.

5. The mounting article according to claim 4, wherein the cover is arranged in such a way that the first shielding body covers the storage, the arranger of the propagator, and the second shielding body together.

6. The mounting article according to claim 1 or 2, wherein
the storage is arranged on a wrist of the user when the mounting article is mounted, and
the mounter includes a strip-shaped member having a strip shape and including the propagator.

7. The mounting article according to claim 6, wherein the strip-shaped member is hooked between fingers of the user when the mounting article is mounted.

8. The mounting article according to claim 6, wherein the strip-shaped member includes a stretch member having stretchability.

9. A reading system comprising a mounting article to be mounted on a user and a reading device to read tag information of a wireless tag, wherein
the mounting article includes
a mounter to be mounted on a body part of the user,
a storage fixed to the mounter and configured to store the reading device, and
a cover to cover the storage,
the mounter includes a propagator including a reader brought close to the wireless tag and an arranger in which the reading device is arranged, the propagator being configured to propagate radio waves used for reading the tag information, and
the cover includes a first shielding body having a sheet shape and configured to cover at least one full periphery of the storage.
